(19) **Europäisches Patentamt / European Patent Office / Office européen des brevets**

(11) **EP 4 014 256 B1**

(12) **EUROPÄISCHE PATENTSCHRIFT**

(45) Veröffentlichungstag und Bekanntmachung des Hinweises auf die Patenterteilung:
**25.10.2023 Patentblatt 2023/43**

(21) Anmeldenummer: **20756788.4**

(22) Anmeldetag: **03.08.2020**

(51) Internationale Patentklassifikation (IPC):
**H01L 31/0224** (2006.01)  **H01L 31/18** (2006.01)

(52) Gemeinsame Patentklassifikation (CPC):
**H01L 31/022425; B41F 15/36; B41N 1/24; H01L 31/18;** B41P 2215/12; Y02E 10/50

(86) Internationale Anmeldenummer:
**PCT/EP2020/071833**

(87) Internationale Veröffentlichungsnummer:
**WO 2021/032456 (25.02.2021 Gazette 2021/08)**

(54) **SIEBDRUCKFORM ZUR VERWENDUNG IN EINEM SIEBDRUCKVERFAHREN, SIEBDRUCKVORRICHTUNG UND SIEBDRUCKVERFAHREN**

SCREEN PRINTING MOULD FOR USE IN A SCREEN PRINTING METHOD, SCREEN PRINTING DEVICE, AND SCREEN PRINTING METHOD

FORME DE SÉRIGRAPHIE DESTINÉE À ÊTRE UTILISÉE DANS UN PROCÉDÉ DE SÉRIGRAPHIE, DISPOSITIF DE SÉRIGRAPHIE ET PROCÉDÉ DE SÉRIGRAPHIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.08.2019 DE 102019122126**

(43) Veröffentlichungstag der Anmeldung:
**22.06.2022 Patentblatt 2022/25**

(73) Patentinhaber: **Fraunhofer-Gesellschaft zur Förderung der angewandten Forschung e.V. 80686 München (DE)**

(72) Erfinder:
• **TEPNER, Sebastian 79110 Freiburg (DE)**
• **POSPISCHIL, Maximilian 79110 Freiburg (DE)**
• **LORENZ, Andreas 79110 Freiburg (DE)**
• **NEY, Linda 79110 Freiburg (DE)**
• **LINSE, Michael 79110 Freiburg (DE)**
• **CLEMENT, Florian 79110 Freiburg (DE)**

(74) Vertreter: **LBP Lemcke, Brommer & Partner Patentanwälte mbB Siegfried-Kühn-Straße 4 76135 Karlsruhe (DE)**

(56) Entgegenhaltungen:
**DE-A1-102007 059 794    US-A1- 2009 025 581**

**Beschreibung**

Die Erfindung betrifft eine Siebdruckform zur Verwendung in einem Siebdruckverfahren, ein zugehöriges Siebdruckverfahren sowie eine Siebdruckvorrichtung zum Aufbringen einer Siebdruckpaste auf ein Substrat.

Zum Aufbringen einer Siebdruckpaste auf ein Substrat ist es bekannt, die Siebdruckpaste mittels einer Rakel durch eine Siebdruckform hindurchzudrücken, um die Siebdruckpaste auf ein Substrat aufzutragen. Die Siebdruckform weist ein Siebdruckgewebe mit einer Vielzahl von länglichen Gewebeelementen, typischerweise Gewebedrähten auf, welches für die Siebdruckpaste durchlässig ist. Um eine Strukturierung der durch die Siebdruckform hindurchtretenden Siebdruckpaste zu erzielen, ist an dem Siebdruckgewebe eine Schablone angeordnet, welche zumindest eine Öffnung aufweist, sodass Siebdruckpaste nur im Bereich der einen oder mehreren Öffnungen der Schablone durch die Siebdruckform hindurchtritt und somit eine durch die Öffnungen vorgegebene Struktur aus Siebdruckpaste auf das Substrat aufgebracht werden kann.

Dokument DE 10 2007 059794 A1 beschreibt eine Schablone für Siebdruck-Verfahren, bestehend aus einem ebenen Schablonen-Körper mit einer Schablonendicke. Dokument US 2009/025581 A1 offenbart eine Maske für den Siebdruck, umfassend einen Maskenkörper, der mehrere Musterbereiche mit Löchern zum Siebdruck aufweist.

In vielen Bereichen ist es wünschenswert, schmale, geradlinige Strukturen aus Siebdruckpaste auf dem Substrat zu erzeugen. Dies ist insbesondere bei der Verwendung eines Siebdruckverfahrens bei der Herstellung photovoltaischer Solarzellen der Fall: Hier ist es bekannt, mittels einer Siebdruckpaste Dotierungen und/oder Metallisierungen an einer Oberfläche einer Halbleiterschicht zu erzeugen, indem die Siebdruckpaste entsprechend Dotierstoffe und/oder Metallpartikel aufweist.

Insbesondere zum Erzeugen sogenannter Metallisierungsfinger einer metallischen Kontaktstruktur zum Kontaktieren einer photovoltaischen Solarzelle ist es wünschenswert, längliche, geradlinige Strukturen aus Siebdruckpaste aufzubringen, welche eine geringe Breite aufweisen, um beispielsweise eine Abschattung einfallender Strahlen durch die Metallisierungsstruktur zu verringern und/oder Rekombinationsverluste an einer Metall-/Halbleiterschnittstelle zu verringern.

Das Erzeugen länglicher, geradliniger Strukturen aus Siebdruckpaste ist jedoch auch bei anderen Anwendungen erforderlich, beispielsweise im Bereich der gedruckten Elektronik, wobei Leiterbahnen und/oder elektronische Bauelemente hergestellt werden.

Der vorliegenden Erfindung liegt daher die Aufgabe zugrunde, eine Siebdruckform, ein Siebdruckverfahren und eine Siebdruckvorrichtung zur Verfügung zu stellen, welche das Aufbringen einer länglichen, geradlinigen Siebdruckstruktur mit geringer Breite und dennoch geringer Schwankung im Materialauftrag ermöglicht.

Gelöst ist diese Aufgabe durch eine Siebdruckform gemäß Anspruch 1, eine Siebdruckvorrichtung gemäß Anspruch 7, ein Druckverfahren gemäß Anspruch 8 sowie die Verwendung einer Siebdruckform gemäß Anspruch 9. Vorteilhafte Ausgestaltungen finden sich in den abhängigen Unteransprüchen.

Die vorliegende Erfindung ist in der Erkenntnis begründet, dass Knotenpunkte, bei welchen sich Gewebeelemente des Siebdruckgewebes kreuzen, zu einem verringerten Auftrag von Siebdruckpaste auf dem Substrat führen können, sodass in Bereichen der Knotenpunkte ein geringerer Materialauftrag an Siebdruckpaste verglichen mit den Bereichen ohne Knotenpunkte erfolgt und somit eine inhomogene Struktur aus Siebdruckpaste entsteht, beispielsweise mit variierender Breite und/oder Höhe.

Dies ist darin begründet, dass in den Bereichen sich überkreuzender Gewebeelemente im Schnitt eine geringere Durchtrittsfläche für Siebdruckpaste vorliegt, verglichen mit Bereichen ohne bzw. mit weniger Kreuzungspunkten.

Insbesondere bei Siebdruckformen zur Herstellung von geradlinigen Strukturen mit geringer Breite ist eine in den Kreuzungspunkten begründete Fehlerquelle eminent, wenn die Breite der Öffnung in der Schablone der Siebdruckform im Bereich oder kleiner als der Abstand von zwei Gewebeelementen ist. In diesen Fällen entstehen erhebliche prozentuale Schwankungen hinsichtlich der aufgetragenen Menge an Siebdruckpaste im Bereich der sich überkreuzenden Gewebeelemente, sodass Nachteile bei der erzeugten Struktur, beispielsweise erhöhte Leitungswiderstände bei einer erzeugten metallischen Kontaktierungsstruktur die Folge sind.

Es ist bekannt, zur Vermeidung dieser Fehlerquellen sogenannte 0°-Gitter zu verwenden. Eine solche Siebdruckform weist eine Vielzahl von Gewebeelementen auf, die in einer ersten Elementrichtung und einer hierzu senkrecht stehenden zweiten Elementrichtung angeordnet sind. Die Elementrichtungen entsprechen somit den Fadenrichtungen bei aus Fäden bestehenden Geweben. Die an dem Siebdruckgewebe angeordnete Schablone weist eine Öffnung in Form eines geradlinigen Kanals auf, beispielsweise eine rechteckige Öffnung. Bei 0°-Gittern verläuft der Kanal in seiner Längserstreckung parallel zu der ersten oder der zweiten Elementrichtung. Weiterhin ist die Breite des Kanals kleiner als der Abstand der Gewebeelemente senkrecht zur Längserstreckung des Kanals. Die Schablone kann somit derart auf dem Siebdruckgewebe angeordnet sein, dass im Bereich des Kanals ausschließlich senkrecht zu dem Kanal verlaufende Gewebeelemente vorliegen und der Kanal somit keinen Knoten, das heißt keine sich überkreuzende Gewebeelemente, aufweist.

Solche 0°-Gitter weisen zum einen den Nachteil auf, dass die Stabilität der Siebdruckform und dadurch auch die Lebensdauer signifikant reduziert ist, da im Kanal ein stark reduzierter Anteil an Gewebeelementen vorliegt und somit eine Sollbruchstelle entsteht. Empirische Untersuchungen zeigen, dass die Lebensdauer eines 0°-Siebs etwa 30 % geringer ist, als die Lebensdauer von Sieben mit einem üblichen Winkel von 22,5° zwischen Kanal und einer der beiden Elementrichtungen. Weiterhin besteht bei 0°-Sieben der Nachteil, dass die Herstellung mit einem signifikant höheren Ausschuss verbunden ist, da eine fehlerhafte Alignierung, das heißt eine fehlerhafte Positionierung des Kanals, relativ zu den parallel zum Kanal verlaufenden Gewebeelemente dazu führt, dass der gesamte Kanal mit einem Draht entlang der Kanalöffnung bedeckt ist und somit die resultierende Öffnungsfläche erheblich minimiert wird. Hierdurch wird eine aufwendige Nachbearbeitung im Herstellungsprozess notwendig oder es liegt eine nicht mehr verwendbare Siebdruckform vor.

Die erfindungsgemäße Siebdruckform ist zur Verwendung in einem Siebdruckverfahren, insbesondere zur Herstellung einer metallischen Kontaktstruktur einer photovoltaischen Solarzelle ausgebildet. Die Siebdruckform weist ein Siebdruckgewebe mit einer Vielzahl von länglichen Gewebeelementen auf, die in einer ersten Elementrichtung und einer hierzu senkrecht stehenden zweiten Elementrichtung angeordnet sind. Das Siebdruckgewebe kann vorteilhafterweise in einem an sich bekannten Siebdruckrahmen, insbesondere einem rechteckigen Siebdruckrahmen der Siebdruckform angeordnet sein. Die länglichen Gewebeelemente sind bevorzugt als Gewebedrähte ausgebildet, ebenso liegt auch die Ausbildung als Gewebefaden im Rahmen der Erfindung.

Die Gewebeelemente der erfindungsgemäßen Siebdruckform stehen bevorzugt in beiden Elementrichtungen mit gleichem Abstand zueinander und weiterhin bevorzugt weisen alle Gewebeelemente den gleichen Durchmesser auf. Bei der Herstellung treten jedoch häufig Fertigungstoleranzen auf. Die Gewebeelemente der erfindungsgemäßen Siebdruckform weisen daher zumindest in erster Elementrichtung einen Abstand AF auf und in zweiter Elementrichtung einen Abstand, der weniger als 5% von AF abweicht, und die Gewebeelemente in erster Elementrichtung einen Durchmesser DG auf und in zweiter Elementrichtung einen Durchmesser, der um weniger als 5% von DG abweicht. Vorteilhaft ist es, dass die Gewebeelemente in erster Elementrichtung einen Abstand AF aufweisen und in zweiter Elementrichtung einen Abstand, der weniger als 2% von AF abweicht, bevorzugt gleich dem Abstand AF ist, und/oder die Gewebeelemente in erster Elementrichtung einen Durchmesser DG aufweisen und in zweiter Elementrichtung einen Durchmesser, der um weniger als 2% von DG abweicht, bevorzugt gleich dem Durchmesser DG ist.

Die erfindungsgemäße Siebdruckform weist weiterhin eine an dem Siebdruckgewebe angeordnete Schablone auf, welche zumindest eine Öffnung in Form eines geradlinigen Kanals aufweist. Der Kanal bildet somit eine langgestreckte, längliche Öffnung in der Schablone aus, welche bevorzugt eine rechteckige Öffnung ist.

Wesentlich ist, dass der Kanal mit der ersten Elementrichtung einen der nachfolgenden Winkel $\varphi$ mit einer Toleranz von +/- 0,1° einschließt und die Kanalbreite BK des Kanals kleiner oder gleich als die dem Winkel $\varphi$ zugeordnete Maximalbreite BKmax ist:

- einen Winkel $\varphi$[°] aus der Gruppe 11,31°, 14,04°, 18,44°, 26,57°, 45° mit einer zugeordneten Maximalbreite BKmax [$\mu$m] gemäß

$$BK_{max} = (2DG + AF)\sin\varphi + DG\cos\varphi$$

oder
- einen Winkel $\varphi$[°] = 33,69°, mit einer zugeordneten Maximalbreite BKmax [$\mu$m] gemäß

$$BK_{max} = (2DG + AF)\cos\varphi - AF\sin\varphi,$$

jeweils mit den vorgenannten Parametern Abstand AF [$\mu$m] und Durchmesser DG [$\mu$m].

Weiterhin ist bei der erfindungsgemäßen Siebdruckform die Kanalbreite BK kleiner als der Abstand zwischen zwei Gewebeelementen in der zweiten Elementrichtung und in der ersten Elementrichtung.

Aufwendige Untersuchungen und Berechnungen der Anmelderin haben gezeigt, dass auch bei nicht parallel zu einer der Elementrichtungen verlaufenden Kanälen Siebdruckformen möglich sind, welche keine Knoten, das heißt keine sich überkreuzenden Gewebeelemente, im Kanalbereich aufweisen oder zumindest eine verringerte Anzahl von Knoten verglichen mit vorbekannten Siebdruckgeweben, bei welchen die Kanäle in einem Winkel von 22,5 zu einer der Elementrichtungen verlaufen.

Ein solcher Vorteil wird jedoch nur mit bestimmten Winkeln erzielt, wobei zusätzlich für jeden Winkel eine Obergrenze der Breite des Kanals gegeben ist, wie in den vorangehenden und in Anspruch 1 aufgeführten Bedingungen BKmax aufgeführt.

Die erfindungsgemäße Siebdruckform weist den Vorteil auf, dass keine oder zumindest eine verringerte Anzahl von Knoten im Kanalbereich vorliegen und vermeidet dennoch Nachteile der 0°-Gitter, insbesondere ist eine erheblich höhere Stabilität verglichen mit den 0°-Gittern gegeben. Weiterhin weist die erfindungsgemäße Siebdruckform den Vorteil auf, dass selbst bei einer fehlerhaften Alignierung keine mit einem großen Mangel oder gar unbrauchbare Siebe entstehen, wie dies bei 0°-Sieben der Fall ist, sondern Siebe, welche in etwa der Qualität der handelsüblichen 22,5°-Sieben entsprechen. Selbst im Fall eines Herstellungsfehlers kann das Produkt somit immer noch für Verfahren verwendet werden, welche lediglich die Qualität an sich bekannter Siebe mit einem Winkel von 22,5° erfordern.

Die Herstellung eines Siebdruckgewebes an sich stellt bereits hohe Anforderungen an die Präzision der verwendeten Apparate. Es ist daher vorteilhaft, dass der Abstand AF der Gewebeelemente in erster Elementrichtung und in zweiter Elementrichtung voneinander um weniger als 2% abweichen, insbesondere, dass der Abstand AF der Gewebeelemente in erster Elementrichtung und in zweiter Elementrichtung gleich ist, und/oder dass der Durchmesser DG der Gewebeelemente in erster Elementrichtung und der Durchmesser der Gewebeelemente in zweiter Elementrichtung um weniger als 2% abweichen, insbesondere, dass der Durchmesser DG der Gewebeelemente in erster Elementrichtung und der Durchmesser der Gewebeelemente in zweiter Elementrichtung gleich ist.

Vorteilhafterweise ist daher der Abstand der Gewebeelemente in erster Elementrichtung und in zweiter Elementrichtung gleich. Hierdurch kann auf handelsüblich erhältliche, qualitativ hochwertige Siebdruckgewebe zurückgegriffen werden.

Die zuvor beschriebenen Vorteile ergeben sich bereits, wenn die Schablone der Siebdruckform - gegebenenfalls neben weiteren Öffnungen, insbesondere nicht geradlinigen Öffnungen - lediglich einen geradlinigen Kanal aufweist, der die voran beschriebenen Bedingungen erfüllt.

In vielen Anwendungsfällen, insbesondere bei der Herstellung photovoltaischer Solarzellen, ist es jedoch vorteilhaft, eine Mehrzahl von geradlinigen, parallel verlaufenden Kanälen in der Schablone vorzusehen, um entsprechend eine Mehrzahl geradlinig und parallel verlaufender Strukturen aus Siebdruckpaste auf das Substrat aufzubringen. Dies ist insbesondere bei der Herstellung von metallischen Kontaktierungsstrukturen einer Solarzelle und/oder selektiver Dotierstrukturen, insbesondere selektiver Emitterstrukturen einer photovoltaischen Solarzelle der Fall.

Vorteilhaftweise weist die Schablone daher mehrere geradlinige, parallele Kanäle auf. Insbesondere ist es vorteilhaft, dass die Schablone zumindest 0,5 Kanäle/mm insbesondere zumindest 1 Kanal/mm aufweist. Insbesondere ist es für typische Substratgrößen vorteilhaft, wenn die Schablone zumindest 50, bevorzugt zumindest 100, insbesondere zumindest 150 Kanäle aufweist. Die Kanalbreite liegt bevorzugt im Bereich 10 $\mu$m bis 150 $\mu$m.

Sofern die Siebdruckform mehrere parallel verlaufende Kanäle aufweist, ist es vorteilhaft, dass die Kanäle einen Abstand aufweisen, welcher einem ganzzahligen Vielfachen des Abstandes der Gewebeelemente in erster und/oder zweiter Elementrichtung entspricht. Es liegt somit insbesondere im Rahmen der Erfindung, dass die Kanäle einen Abstand aufweisen, welcher einem ganzzahligen Vielfachen sowohl des Abstandes der Gewebeelemente in erster Elementrichtung, als auch in zweiter Elementrichtung entspricht. Dies ist stets der Fall, sofern wie zuvor beschrieben in einer vorteilhaften Ausbildungsform der Abstand der Gewebeelemente in erster und zweiter Elementrichtung gleich ist.

Hierdurch ergibt sich der Vorteil, dass eine optimale Alignierung eines Kanals stets auch eine optimale Alignierung aller mit der vorangegebenen Bedingung parallel verlaufender Kanäle ergibt.

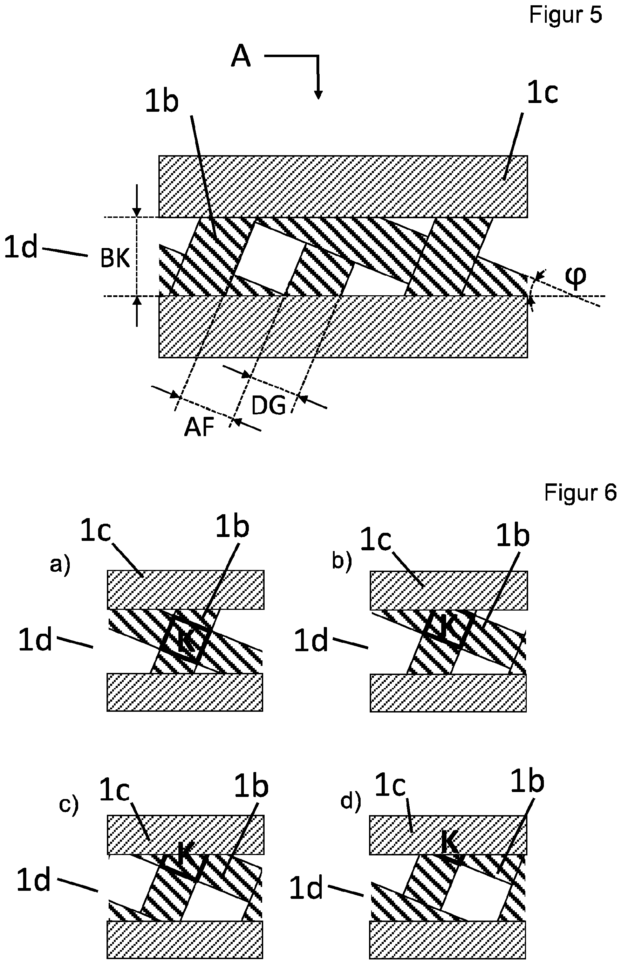

Eine detaillierte Untersuchung der Anordnung von Knoten bei Gewebeelementen mit einer ersten und einer hierzu senkrecht stehenden zweiten Elementrichtung zeigt, dass zwischen vier Typen von Knotenarten unterschieden werden kann. Zwei sich kreuzende Gewebeelemente kann einem Knoten mit vier Ecken zugeordnet werden. Dies wird weiter unten auch in der Figurenbeschreibung anhand von Figur 6 näher erläutert.

Die in der eingangs und in Anspruch 1 aufgeführten Bedingungen führen dazu, dass keine Knoten mit allen vier zugehörigen Ecken im Öffnungsbereich des Kanals liegen (Bedingung BKmax = BK$_{max321}$) oder zumindest nur eine deutlich verringerte Anzahl. Vorteilhaft ist jedoch, wenn auch die Anzahl von Knoten, welche mit zwei oder einer Ecke (Bedingung BKmax = BK$_{max21}$), weiter bevorzugt mit nur einer Ecke (Bedingung BKmax = BK$_{max1}$) im Bereich der Kanalöffnung liegen, vermieden oder zumindest verringert wird. Besonders vorteilhaft ist es, wenn keine Ecke eines Knotens im Bereich der Kanalöffnung liegen oder zumindest deren Anzahl deutlich verringert wird (Bedingung BKmax = BK$_{max0}$).

Hierdurch wird die Homogenität der erzeugten Struktur aus Siebdruckpaste weiter verbessert.

Es ist daher zum Erreichen der vorgenannten Bedingungen vorteilhaft, dass der Kanal mit der ersten Elementrichtung einen der nachfolgenden Winkel $\varphi$ mit einer Toleranz von +/- 0,1° einschließt und die Kanalbreite BK des Kanals kleiner oder gleich als die dem Winkel $\varphi$ zugeordnete Maximalbreite BKmax ist:

- einen Winkel $\varphi$[°] aus der Gruppe 11,31°, 14,04°, 18,44°, 26,57°, 45° mit einer zugeordneten Maximalbreite BKmax [$\mu$m] gemäß

$$BK_{max,21} = AF \sin \varphi + DG \cos \varphi$$

oder
- einen Winkel $\varphi[°] = 33{,}69°$, mit einer zugeordneten Maximalbreite BKmax $[\mu m]$ gemäß

$$BK_{max,21} = (2DG + AF)(\cos \varphi - \sin \varphi)$$

insbesondere,

dass der Kanal mit der ersten Elementrichtung einen der nachfolgenden Winkel $\varphi$ mit einer Toleranz von +/- 0,1° einschließt und die Kanalbreite BK des Kanals kleiner oder gleich als die dem Winkel $\varphi$ zugeordnete Maximalbreite BKmax ist:

- einen Winkel $\varphi[°]$ aus der Gruppe $11{,}31°$, $14{,}04°, 18{,}44°, 26{,}57°, 45°$ mit einer zugeordneten Maximalbreite BKmax $[\mu m]$ gemäß

$$BK_{max,1} = (2DG + AF) \sin \varphi - DG \cos \varphi$$

oder
- einen Winkel $\varphi[°] = 33{,}69°$, mit einer zugeordneten Maximalbreite BKmax $[\mu m]$ gemäß

$$BK_{max,1} = AF(\cos \varphi - \sin \varphi)$$

bevorzugt,

dass der Kanal (1d) mit der ersten Elementrichtung einen der nachfolgenden Winkel $\varphi$ mit einer Toleranz von +/- 0,1° einschließt und die Kanalbreite BK des Kanals kleiner oder gleich als die dem Winkel $\varphi$ zugeordnete Maximalbreite BKmax ist:

- einen Winkel $\varphi[°]$ aus der Gruppe $11{,}31°$, $14{,}04°, 18{,}44°, 26{,}57°, 45°$ mit einer zugeordneten Maximalbreite $BK_{max}$ $[\mu m]$ gemäß

$$BK_{max,0} = AF \sin \varphi - DG \cos \varphi$$

oder
- einen Winkel $\varphi[°] = 33{,}69°$, mit einer zugeordneten Maximalbreite $BK_{max}$ $[\mu m]$ gemäß

$$BK_{max,0} = AF \cos \varphi - (2DG + AF) \sin \varphi \,.$$

Untersuchungen der Anmelderin zeigen, dass bei den Bedingungen BKmax = $BK_{max1}$ und BKmax = $BK_{max0}$ nicht für alle Verhältnisse von Abstand AF und Durchmesser DG Lösungen existieren. Vorteilhafterweise sind Abstand AF und Durchmesser DG daher derart gewählt, dass
- bei Bedingung BKmax = $BK_{max1}$ und einem Winkel $\varphi[°]$ aus der Gruppe $11{,}31°$, $14{,}04°, 18{,}44°, 26{,}57°, 45°$ zusätzlich die Bedingung

$$\varphi > \tan^{-1}\left(\frac{DG}{DG + AF}\right)$$

gilt und bei Winkel $\varphi[°] = 33{,}69°$ zusätzlich die Bedingung

$$\varphi > \tan^{-1}\left(\frac{AF}{AF + DG}\right)$$

gilt,

- bei Bedingung BKmax = $BK_{max0}$ und einem Winkel $\varphi[°]$ aus der Gruppe 11,31°, 14,04°,18,44°,26,57°,45° zusätzlich die Bedingung

$$\varphi > tan^{-1}\left(\frac{DG}{AF}\right)$$

gilt und bei Winkel $\varphi[°]$ = 33,69° zusätzlich die Bedingung

$$\varphi > tan^{-1}\left(\frac{AF}{AF + DG}\right)$$

gilt.

In der nachfolgenden Tabelle sind exemplarisch Bedingungen für vorteilhafte Ausführungsformen der erfindungsgemäßen Siebdruckform aufgeführt, welche zu den vorgenannten Verbesserungen führen. Die Berechnung der Werte von BKmax werden für ein Gewebe mit den Parametern Drahtzahl (480 Drähte pro inch, AF=41,92 $\mu$m) und Drahtdurchmesser (DG=11 $\mu$m) durchgeführt. Der Index "321" weist darauf hin, dass nur Knoten mit drei, zwei oder einem Eckpunkt (analog zu der Bedingung in Anspruch 1), "21", zwei oder einem Eckpunkt, "1", dass nur Knoten mit einem Eckpunkt, "0", kein Knoteneckpunkt im Kanal vorkommt (analog zu den Bedingungen in Anspruch 5). Voraussetzung dafür ist die korrekte Alignierung des Kanals auf dem Gewebe:

| $\varphi[°]$ | $BKmax_{,321}$ [$\mu$m] | $BKmax_{,21}$ [$\mu$m] | $BKmax_{,1}$ [$\mu$m] | $BKmax_{,0}$ [$\mu$m] |
|---|---|---|---|---|
| 45 +/- 0,1 | 53,0 | 37,4 | 37,4 | 21,9 |
| 33,69 +/- 0,1 | 30,0 | 17,7 | - | - |
| 26,57 +/- 0,1 | 38,4 | 28,6 | 18,8 | 8,9 |
| 18,44 +/- 0,1 | 30,7 | 23,7 | 9,8 | 2,8 |
| 14,04 +/- 0,1 | 26,2 | 20,8 | 4,8 | - |
| 11,31 +/- 0,1 | 23,3 | 19,0 | - | - |

Die eingangs erwähnte Aufgabe ist weiterhin durch eine Siebdruckvorrichtung zum Aufbringen einer Siebdruckpaste auf ein Substrat gelöst. Die Siebdruckvorrichtung weist eine erfindungsgemäße Siebdruckform, insbesondere eine bevorzugte Ausführungsform hiervon auf sowie zumindest eine Rakel. Die Siebdruckvorrichtung ist ausgebildet, mittels der Rakel Siebdruckpaste durch die Siebdruckform hindurch auf ein Substrat aufzubringen. Die erfindungsgemäße Siebdruckvorrichtung unterscheidet sich im Grundaufbau daher nicht von vorbekannten Siebdruckvorrichtungen, wobei jedoch die Siebdruckform die besondere Ausgestaltung wie zuvor beschrieben aufweist.

Insbesondere kann die Siebdruckvorrichtung in einer vorteilhaften Ausgestaltung als an sich bekannte Flachbett-Siebdruckvorrichtung ausgebildet sein. Ebenso liegt es im Rahmen der Erfindung, dass die Siebdruckvorrichtung als an sich bekannte Rotationssiebdruckvorrichtung ausgebildet ist.

Entsprechend liegt es im Rahmen der Erfindung, dass die erfindungsgemäße Siebdruckform zur Verwendung in einem Flachbett-Siebdruckverfahren ausgebildet ist und insbesondere im Wesentlichen eine ebene Form aufweist. Ebenso liegt es im Rahmen der Erfindung, dass die erfindungsgemäße Siebdruckform zur Verwendung in einem Rotationssiebdruckverfahren ausgebildet ist, insbesondere, dass die Siebdruckform eine zylindrische oder zumindest teilzylindrische Form aufweist.

Die eingangs genannte Aufgabe ist weiterhin durch ein Druckverfahren zum Aufbringen einer Siebdruckpaste auf ein Substrat gelöst, wobei mittels zumindest einer Rakel Siebdruckpaste durch eine Siebdruckform auf ein Substrat aufgebracht wird. Wesentlich ist, dass die Siebdruckform gemäß der zuvor beschriebenen erfindungsgemäßen Siebdruckform, insbesondere einer bevorzugten Ausführungsform hiervon, ausgebildet ist.

Die eingangs genannte Aufgabe ist weiterhin ebenfalls durch die Verwendung einer erfindungsgemäßen Siebdruckform, insbesondere einer besonders bevorzugten Ausführungsform hiervon, bei einem Siebdruckverfahren gelöst.

Die vorangehend beschriebenen Bedingungen dienen zur Vermeidung oder zumindest Verringerung von Knoten im Kanal der Siebdruckform. Hierzu ist es vorteilhaft, eine möglichst genaue Einhaltung des jeweils vorgegebenen Winkels zu erzielen. Es ist daher vorteilhaft eine Winkeltoleranz von +/- 0,05°, insbesondere von +/- 0,01° zu erzielen.

Weitere vorteilhafte Merkmale und bevorzugte Ausführungsformen werden im Folgenden anhand von Ausführungsbeispielen und den Figuren erläutert. Dabei zeigt

Figur 1    eine erste Ausführungsform einer erfindungsgemäßen Siebdruckvorrichtung zum Flachbett-Siebdruck;

Figur 2    eine zweite Ausführungsform einer erfindungsgemäßen Siebdruckvorrichtung zum Rotationssiebdruck;

Figur 3    eine Schnittdarstellung eines Ausführungsbeispiels einer erfindungsgemäßen Siebdruckform der Siebdruckvorrichtung gemäß Figur 1;

Figur 4    eine Draufsicht von oben auf die Siebdruckform gemäß Figur 3;

Figur 5    eine Ausschnittsvergrößerung aus Figur 4;

Figur 6    Teildarstellungen zur Erläuterung von Ausschlusskriterien des Vorliegens von Knotenanteilen und

Figur 7    Teilausschnitte mehrerer weiterer Ausführungsbeispiele erfindungsgemäßer Siebdruckformen.

Die Figuren zeigen schematische, nicht maßstabsgetreue Darstellungen. Gleiche Bezugszeichen in den Figuren bezeichnen gleiche oder gleichwirkende Elemente.

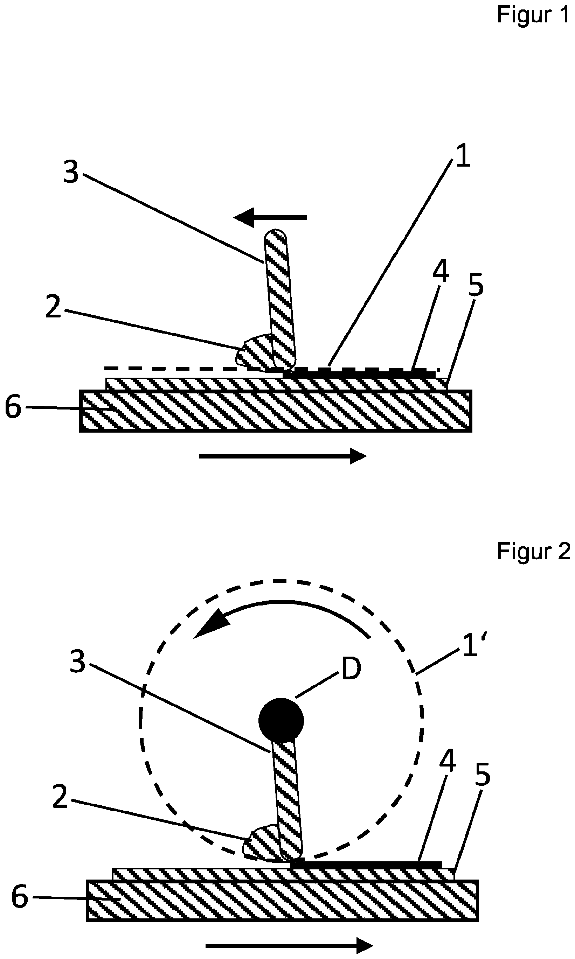

In Figur 1 ist ein erstes Ausführungsbeispiel einer erfindungsgemäßen Siebdruckvorrichtung in Seitenansicht dargestellt. Die Vorrichtung ist zum Durchführen eines Flachbett-Siebdruckverfahrens ausgebildet.

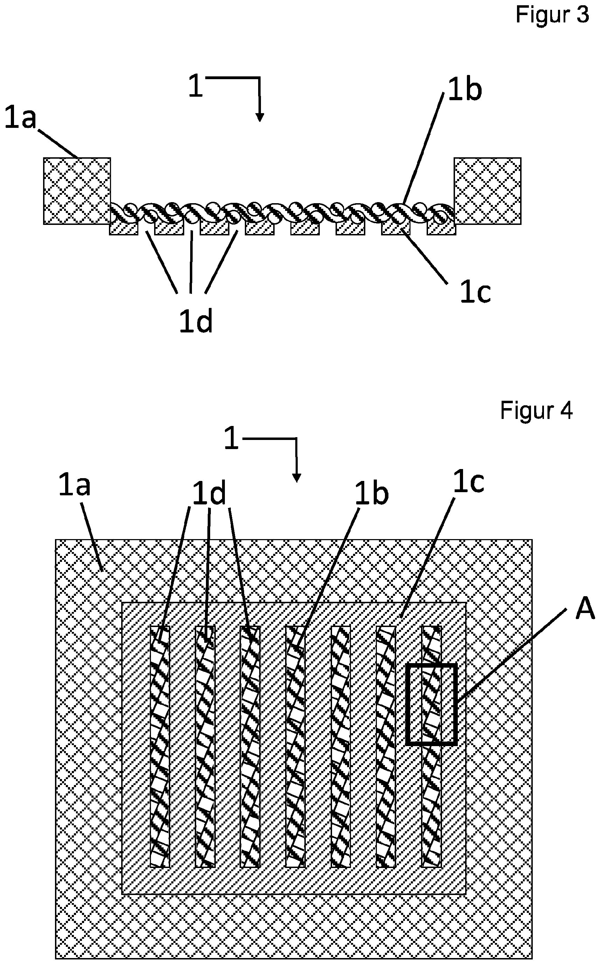

Die Vorrichtung weist eine Siebdruckform 1 auf, welche als Flachbett-Siebdruckform ausgebildet ist. Die Siebdruckform 1 ist teilweise für eine Siebdruckpaste 2 durchlässig und teilweise für die Siebdruckpaste 2 undurchlässig ausgebildet, um eine vorgegebene Struktur auszubilden. Dies wird nachfolgend anhand der Figuren 3 und 4 näher erläutert.

Bei der Druckpaste 2 handelt es sich vorliegend um eine Metallpartikel enthaltende Druckpaste, welche dazu dient, nach thermischer Behandlung eine metallische Kontaktierungsstruktur in Form eines an sich bekannten Kontaktierungsgitters auf der Vorderseite einer photovoltaischen Solarzelle auszubilden.

Die Vorrichtung weist eine Rakel 3 auf, welche entlang der durch den über der Rakel abgebildeten Pfeil angegebenen Richtung mittels nicht dargestellter motorischer Mittel bewegt werden kann. Hierdurch wird die Siebdruckpaste 2 über die Siebdruckform 1 gestrichen und durchdringt die Siebdruckform 1 an den durchlässigen Stellen, sodass die Struktur 4 aus Siebdruckpaste auf einem Substrat 5 aufgebracht wird.

Das Substrat 5 ist vorliegend als Siliziumwafer ausgebildet, welcher bereits p- und n-dotierte Bereiche zum Ausbilden von Emitter und Basis aufweist. Das Substrat 5 stellt somit einen Solarzellen-Precursor dar, zur Fertigstellung der Solarzelle bedarf es weiterhin des Anordnens der metallischen Kontaktierungsstruktur auf der Vorderseite des Halbleitersubstrates 5.

Die Vorrichtung weist eine Zuführeinheit zum Zu- und Abführen von Halbleitersubstraten auf, welche ein (nicht dargestelltes) Förderband aufweist, auf dem mehrere Shuttles angeordnet sind. Beispielhaft ist in Figur 1 ein Shuttle 6 mit darauf liegendem Substrat 5 dargestellt.

In Figur 2 ist als alternative Ausführungsform ein zweites Ausführungsbeispiel einer erfindungsgemäßen Druckvorrichtung dargestellt. Diese Druckvorrichtung ist zur Durchführung eines Rotationssiebdruckverfahrens ausgebildet. Wie ein Vergleich der Figuren 1 und 2 zeigt, sind einige Elemente identisch ausgebildet und angeordnet. Wesentlich ist jedoch, dass bei dem zweiten Ausführungsbeispiel gemäß Figur 2 die Siebdruckform 1' als Rundsieb mit einer zylindrischen Form ausgebildet ist. Die Rakel 3 ist im Inneren der zylindrisch ausgebildeten Siebdruckform 1' angeordnet, sodass die Druckpaste 2 aus dem Inneren der Siebdruckform 1' durch die Siebdruckform hindurch nach außen gedrückt wird, um die Struktur 4 aus Druckpaste auf dem Substrat 5 auszubilden.

Hierzu weist die als Rundsieb ausgebildete Siebdruckform 1' eine Drehachse 1a auf und ist mittels motorischer Mittel in der durch den Kreisbogenpfeil gekennzeichneten Richtung drehbar. Die Drehachse 1a steht somit in Figur 2 senkrecht zur Zeichenebene.

Gleichzeitig wird mittels des Shuttles 6 das Halbleitersubstrat 5 in der als geradliniger Pfeil dargestellten Richtung bewegt, derart, dass die Relativgeschwindigkeit zwischen Substrat 5 und Mantelfläche der Siebdruckform 1' am Berührungspunkt zwischen Siebdruckform 1' und Substrat 5 Null oder zumindest vernachlässigbar gering ist.

Die Rakel 3 führt hingegen keine Drehbewegung durch, sodass die Druckpaste 2 im Inneren der Siebdruckform 1' aufgrund der Drehbewegung der Siebdruckform 1' gegen die Rakel 3 gedrückt wird und mittels der Rakel durch die Siebdruckform hindurch auf das Substrat 5 aufgebracht wird.

Die Siebdruckformen 1 und 1' sind grundsätzlich gleich aufgebaut, lediglich weist die Siebdruckform 1 eine ebene, rechteckige Form auf, wohingegen die Form der Siebdruckform 1' der Mantelfläche eines Zylinders entspricht.

In Figur 3 ist ein Querschnitt durch die Siebdruckform 1 der Vorrichtung gemäß Figur 1 dargestellt. Die Siebdruckform 1 weist einen rechteckigen Rahmen 1a auf, in welchem ein Siebdruckgewebe 1b gespannt ist. Das Siebdruckgewebe 1b weist eine Vielzahl von Gewebeelementen auf, die in einer ersten Elementrichtung und einer senkrecht stehenden Elementrichtung angeordnet sind. Die erste Elementrichtung steht gemäß Figur 3 senkrecht zur Zeichenebene und entsprechend liegt die zweite Elementrichtung gemäß der Darstellung in Figur 3 parallel zur Zeichenebene.

An dem Siebdruckgewebe 1b ist eine Schablone 1c angeordnet, welche in an sich bekannter Weise als Emulsion ausgebildet ist. Die Schablone 1c weist eine Vielzahl von Öffnungen auf, die jeweils als geradliniger, länglicher Kanal 1d ausgebildet sind. Die Kanäle der Siebdruckform 1 verlaufen parallel zueinander und senkrecht zur Zeichenebene gemäß Figur 3 und weisen vorliegend identische Breiten auf. Exemplarisch sind in Figur 3 drei Kanäle 1d gekennzeichnet.

Wird nun in Figur 3 von oben mittels der Rakel Siebdruckpaste auf die Siebdruckform 1 gedrückt, so kann die Siebdruckpaste die Siebdruckform nur im Bereich der Kanäle 1d durchdringen, sodass entsprechend der Positivform der Kanäle eine Struktur aus Siebdruckpaste auf einem unter der Figur 3 liegenden Substrat erzeugt wird, welche aus einer entsprechenden Vielzahl parallel nebeneinander angeordneter Linien aus Siebdruckpaste besteht.

In Figur 4 ist eine Rückansicht von unten auf die Siebdruckform 1 gemäß Figur 3 gezeigt. Schematisch ist dargestellt, dass im Bereich der Öffnungen der Schablone 1c, das heißt im Bereich der Kanäle 1d, die Siebdruckform nicht vollständig geöffnet ist, da unterhalb der Kanäle 1d Gewebeelemente des Siebdruckgewebes 1b verlaufen.

Die erfindungsgemäßen Siebdruckformen zeichnen sich dadurch aus, dass in den Bereichen der Kanäle 1d keine oder zumindest eine verringerte Anzahl von Knoten des Siebdruckgewebes 1b liegen, sodass eine homogene Struktur aus Siebdruckpaste erzeugt werden kann. Dennoch verlaufen die Gewebeelemente des Siebdruckgewebes 1b nicht senkrecht zur Längserstreckung der Kanäle 1d, das heißt in Figur 4 nicht waagerecht, wie dies bei einer 0°-Siebdruckform der Fall wäre. Dies wird in Figur 5 näher anhand eines Ausschnitts aus Figur 4 erläutert:

Figur 5 zeigt in waagrechter Darstellung den mit A gekennzeichneten Ausschnitt aus Figur 4. Gekennzeichnet sind die Längenmaße der Kanalbreite BK, des Durchmessers der Gewebeelemente DG und des Abstands zwischen zwei parallelen Gewebeelementen (Freifläche) AF sowie der Winkel $\varphi$ zwischen Gewebeelementen und Kanalkante.

In Figur 6 sind unterschiedliche Überdeckungsarten dargestellt, um das Vorliegen eines Knotens, das heißt eines überkreuzten Bereiches zweier senkrecht zueinander verlaufender Gewebeelemente, im Öffnungsbereich der Schablone 1c, das heißt innerhalb eines Kanals 1d, zu verdeutlichen.

In Figur 6 sind die Außenbegrenzungen der Knoten K durch verstärkte Linien gekennzeichnet.

Wie in Figur 6a ersichtlich, kann ein Knoten K derart angeordnet sein, dass alle vier Ecken innerhalb des Kanals 1d liegen. Dies stellt eine ungünstige Anordnung dar, denn der Knoten K führt zu einer hohen Flächenabdeckung innerhalb des Kanals 1d, sodass ein hohes Risiko eines inhomogenen Pastenauftrags in Längsrichtung des Kanals 1d besteht. Die Situation gemäß Figur 6a wird durch die in Anspruch 1 genannten Bedingungen vermieden oder zumindest erheblich reduziert.

Vorteilhaft ist es jedoch, wenn eine reduzierte Anzahl der Eckpunkte des Knotens K im Bereich des Kanals 1d vorliegt. So ist bei der Anordnung gemäß Figur 6b zwar eine Ecke des Knotens K (die linke obere Ecke) bereits unterhalb der Schablone 1c angeordnet. Dennoch verbleiben drei Ecken des Knotens K innerhalb des Kanals 1d, sodass zwar ein reduziertes, aber immer noch ein Risiko eines inhomogenen Pastenauftrages besteht.

Entsprechend ist es weiter vorteilhaft, gemäß der Darstellung in Figur 6c die Anordnung derart zu wählen, dass lediglich zwei der Eckpunkte des Knotens K innerhalb des Kanals 1d liegen, wohingegen die anderen beiden Eckpunkte sich unter der Schablone 1c befinden. Weiter vorteilhaft ist es, entsprechend Figur 6d, wenn sich nur noch lediglich ein Eckpunkt des Knotens K in dem Kanal 1d befindet.

Besonders vorteilhaft ist es entsprechend, wenn gar kein Eckpunkt des Knotens K sich innerhalb des Kanals 1d befindet, sodass die Anordnung als "knotenfrei" bezeichnet werden kann.

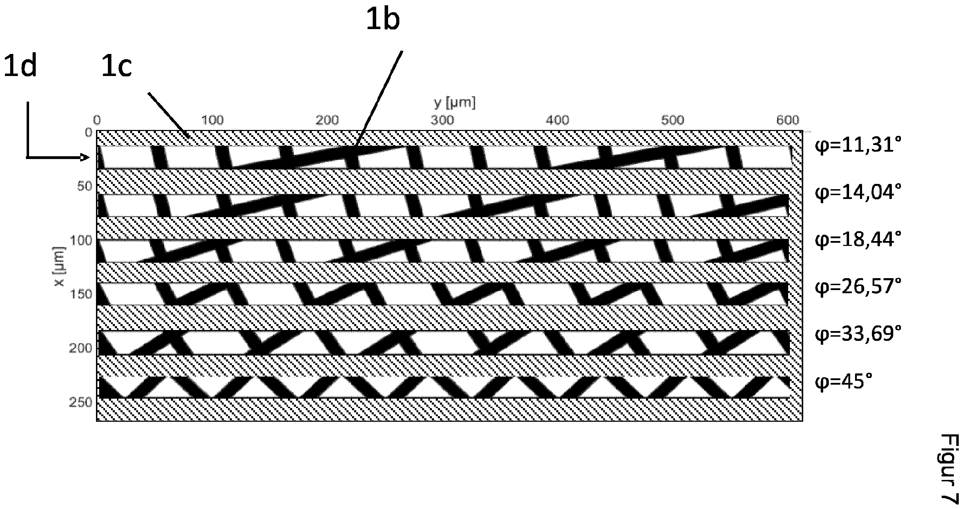

In Figur 7 sind verschiedene alternative Ausführungsbeispiele einer erfindungsgemäßen Siebdruckform mit zugehörigen Parametern gezeigt.

Bezugszeichenliste

| | |
|---|---|
| 1,1' | Siebdruckform |
| 1a | Rahmen |
| 1b | Siebdruckgewebe |
| K | Knoten |
| 1c | Schablone |
| 1d | Kanal |
| D | Drehachse |

| | |
|---|---|
| 2 | Siebdruckpaste |
| 3 | Rakel |
| 4 | Struktur aus Druckpaste |
| 5 | Halbleitersubstrat |
| 6 | Shuttle |

**Patentansprüche**

1. Siebdruckform (1,1') zur Verwendung in einem Siebdruckverfahren, insbesondere zur Herstellung einer metallischen Kontaktstruktur einer photovoltaischen Solarzelle,

   mit einem Siebdruckgewebe (1b) mit einer Vielzahl von länglichen Gewebeelementen, die in einer ersten Elementrichtung und einer hierzu senkrecht stehenden zweiten Elementrichtung angeordnet sind und mit einer an dem Siebdruckgewebe (1b) angeordneten Schablone (1c), welche zumindest eine Öffnung in Form eines geradlinigen Kanals mit einer Kanalbreite BK aufweist,
   wobei die Gewebeelemente in erster Elementrichtung einen Abstand AF aufweisen und in zweiter Elementrichtung einen Abstand, der weniger als 5% von AF abweicht, und die Gewebeelemente in erster Elementrichtung einen Durchmesser DG aufweisen und in zweiter Elementrichtung einen Durchmesser, der um weniger als 5% von DG abweicht,
   **dadurch gekennzeichnet,**
   **dass** der Kanal (1d) mit der ersten Elementrichtung einen der nachfolgenden Winkel φ mit einer Toleranz von +/- 0,1° einschließt und die Kanalbreite BK des Kanals kleiner oder gleich als die dem Winkel φ zugeordnete Maximalbreite BKmax ist:

   - einen Winkel φ[°] aus der Gruppe 11,31°, 14,04°,18,44°,26,57°,45° mit einer zugeordneten Maximalbreite BKmax [μm] gemäß

$$BK_{max} = (2DG + AF)\sin\varphi + DG\cos\varphi$$

   oder
   - einen Winkel φ[°] = 33,69°, mit einer zugeordneten Maximalbreite BKmax [μm] gemäß

$$BK_{max} = (2DG + AF)\cos\varphi - AF\sin\varphi$$

   und **dass** die Kanalbreite BK kleiner als der Abstand zwischen zwei Gewebeelementen in der zweiten Fadenrichtung und in der ersten Fadenrichtung ist.

2. Siebdruckform (1,1') nach Anspruch 1,
   **dadurch gekennzeichnet,**
   **dass** die Gewebeelemente in erster Elementrichtung einen Abstand AF aufweisen und in zweiter Elementrichtung einen Abstand, der weniger als 2% von AF abweicht, bevorzugt gleich dem Abstand AF ist,
   und/oder die Gewebeelemente in erster Elementrichtung einen Durchmesser DG aufweisen und in zweiter Elementrichtung einen Durchmesser, der um weniger als 2% von DG abweicht, bevorzugt gleich dem Durchmesser DG ist.

3. Siebdruckform (1,1') nach einem der vorangegangenen Ansprüche,
   **dadurch gekennzeichnet,**
   **dass** die Schablone (1c) mehrere geradlinige, parallele Kanäle aufweist, insbesondere zumindest 0,5 Kanäle / mm.

4. Siebdruckform (1,1') nach Anspruch 3,
   **dadurch gekennzeichnet,**
   **dass** die Kanäle einen Abstand aufweisen, welcher einem ganzzahligen Vielfachen des Abstandes der Gewebeelemente in erster und/oder zweiter Fadenrichtung entspricht.

5. Siebdruckform (1,1') nach einem der vorangegangenen Ansprüche,
   **dadurch gekennzeichnet,**

**dass** der Kanal (1d) mit der ersten Elementrichtung einen der nachfolgenden Winkel φ mit einer Toleranz von +/- 0,1° einschließt und die Kanalbreite BK des Kanals kleiner oder gleich als die dem Winkel φ zugeordnete Maximalbreite BKmax ist:

- einen Winkel φ[°] aus der Gruppe 11,31°, 14,04°,18,44°,26,57°,45° mit einer zugeordneten Maximalbreite BKmax [μm] gemäß

$$BK_{max,21} = AF \sin \varphi + DG \cos \varphi$$

oder
- einen Winkel φ[°] = 33,69°, mit einer zugeordneten Maximalbreite BKmax [μm] gemäß

$$BK_{max,21} = (2DG + AF)(\cos \varphi - \sin \varphi)$$

insbesondere,

**dass** der Kanal (1d) mit der ersten Elementrichtung einen der nachfolgenden Winkel φ mit einer Toleranz von +/- 0,1° einschließt und die Kanalbreite BK des Kanals kleiner oder gleich als die dem Winkel φ zugeordnete Maximalbreite BKmax ist:

- einen Winkel φ[°] aus der Gruppe 11,31°, 14,04°,18,44°,26,57°,45° mit einer zugeordneten Maximalbreite $BK_{max}$ [μm] gemäß

$$BK_{max,1} = (2DG + AF) \sin \varphi - DG \cos \varphi$$

oder
- einen Winkel φ[°] = 33,69°, mit einer zugeordneten Maximalbreite BKmax [μm] gemäß

$$BK_{max,1} = AF(\cos \varphi - \sin \varphi)$$

bevorzugt,

**dass** der Kanal (1d) mit der ersten Elementrichtung einen der nachfolgenden Winkel φ mit einer Toleranz von +/- 0,1° einschließt und die Kanalbreite BK des Kanals kleiner oder gleich als die dem Winkel φ zugeordnete Maximalbreite BKmax ist:

- einen Winkel φ[°] aus der Gruppe 11,31°, 14,04°,18,44°,26,57°,45° mit einer zugeordneten Maximalbreite $BK_{max}$ [μm] gemäß

$$BK_{max,0} = AF \sin \varphi - DG \cos \varphi$$

oder
- einen Winkel φ[°] = 33,69°, mit einer zugeordneten Maximalbreite BKmax [μm] gemäß

$$BK_{max,0} = AF \cos \varphi - (2DG + AF) \sin \varphi \,.$$

6. Siebdruckform (1,1') nach Anspruch 5,
   **dadurch gekennzeichnet,**
   **dass** Abstand AF und Durchmesser DG daher derart gewählt sind, dass

   - bei Bedingung BKmax = $BK_{max1}$ und einem Winkel φ[°] aus der Gruppe 11,31°, 14,04°,18,44°,26,57°,45° zusätzlich die Bedingung

$$\varphi > \tan^{-1}\left(\frac{DG}{DG + AF}\right)$$

gilt und bei Winkel φ[°] = 33,69° zusätzlich die Bedingung

$$\varphi > \tan^{-1}\left(\frac{AF}{AF + DG}\right)$$

gilt,
- bei Bedingung BKmax = $BK_{max0}$ und einem Winkel φ[°] aus der Gruppe 11,31°, 14,04°,18,44°,26,57°,45° zusätzlich die Bedingung

$$\varphi > tan^{-1}\left(\frac{DG}{AF}\right)$$

gilt und bei Winkel φ[°] = 33,69° zusätzlich die Bedingung

$$\varphi > tan^{-1}\left(\frac{AF}{AF + DG}\right)$$

gilt.

7. Siebdruckvorrichtung zum Aufbringen einer Siebdruckpaste (2) auf ein Substrat,

mit einer Siebdruckform (1,1') gemäß einem der vorangegangen Ansprüchen, und zumindest einer Rakel (3), wobei die Siebdruckvorrichtung ausgebildet ist, mittels der Rakel Siebdruckpaste (2) durch die Siebdruckform (1,1') hindurch auf ein Substrat aufzubringen.

8. Siebdruckverfahren zum Aufbringen einer Siebdruckpaste (2) auf ein Substrat,

wobei mittels zumindest einer Rakel (3) Siebdruckpaste (2) durch eine Siebdruckform (1,1') auf eine Substrat aufgebracht wird,
**dadurch gekennzeichnet,**
**dass** eine Siebdruckform (1,1') gemäß einem der Ansprüche 1 bis 5 verwendet wird.

9. Verwendung einer Siebdruckform (1,1') gemäß einem der Ansprüche 1 bis 5 bei einem Siebdruckverfahren.

**Claims**

1. Screen-printing forme (1, 1') for use in a screen-printing process, especially in the production of a metal contact structure of a photovoltaic solar cell, having a screen-printing fabric (1b) with a multiplicity of elongate woven fabric elements which are arranged in a first element direction and in a second element direction perpendicular thereto,

and having a stencil (1c) arranged on the screen-printing fabric (1b), which stencil has at least one opening in the form of a rectilinear channel having a channel width BK, wherein the woven fabric elements have, in the first element direction, a spacing AF and, in the second element direction, a spacing which differs from AF by less than 5 %, and the woven fabric elements have, in the first element direction, a diameter DG and, in the second element direction, a diameter which differs from DG by less than 5 %,
**characterised in that**
the channel (1d) encloses with the first element direction one of the following angles φ with a tolerance of +/- 0.1° and the channel width BK of the channel is smaller than or equal to the maximum width BKmax assigned to the angle φ:

11

- an angle φ[°] from the group 11.31°, 14.04°,18.44°, 26.57°, 45° with an assigned maximum width BKmax [μm] in accordance with

$$BK_{max} = (2DG + AF) \sin \varphi + DG \cos \varphi$$

or
- an angle φ[°] = 33.69°, with an assigned maximum width BKmax [μm] in accordance with

$$BK_{max} = (2DG + AF) \cos \varphi - AF \sin \varphi \,;$$

and the channel width BK is smaller than the spacing between two woven fabric elements in the second thread direction and in the first thread direction.

2. Screen-printing forme (1, 1') according to claim 1,
**characterised in that**

the woven fabric elements have, in the first element direction, a spacing AF and, in the second element direction, a spacing which differs from AF by less than 2 %, preferably being equal to the spacing AF,
and/or the woven fabric elements have, in the first element direction, a diameter DG and, in the second element direction, a diameter which differs from DG by less than 2 %, preferably being equal to the diameter DG.

3. Screen-printing forme (1, 1') according to either one of the preceding claims,
**characterised in that**
the stencil (1c) has a plurality of rectilinear, parallel channels, especially at least 0.5 channel/mm.

4. Screen-printing forme (1, 1') according to claim 3,
**characterised in that**
the channels have a spacing that corresponds to an integer multiple of the spacing of the woven fabric elements in the first and/or second thread direction(s).

5. Screen-printing forme (1, 1') according to any one of the preceding claims,
**characterised in that**

the channel (1d) encloses with the first element direction one of the following angles φ with a tolerance of +/- 0.1° and the channel width BK of the channel is smaller than or equal to the maximum width BKmax assigned to the angle φ:

- an angle φ[°] from the group 11.31°, 14.04°,18.44°, 26.57°, 45° with an assigned maximum width BKmax [μm] in accordance with

$$BK_{max,21} = AF \sin \varphi + DG \cos \varphi$$

or
- an angle φ[°] = 33.69°, with an assigned maximum width BKmax [μm] in accordance with

$$BK_{max,21} = (2DG + AF)(\cos \varphi - \sin \varphi);$$

especially,

the channel (1d) encloses with the first element direction one of the following angles φ with a tolerance of +/- 0.1° and the channel width BK of the channel is smaller than or equal to the maximum width BKmax assigned to the angle cp:

- an angle φ[°] from the group 11.31°, 14.04°, 18.44°, 26.57°, 45° with an assigned maximum width BKmax

[μm] in accordance with

$$BK_{max,1} = (2DG + AF)\sin\varphi - DG\cos\varphi$$

or
- an angle $\varphi[°] = 33.69°$, with an assigned maximum width BKmax [μm] in accordance with

$$BK_{max,1} = AF\,(\cos\varphi - \sin\varphi);$$

preferably,

the channel (1d) encloses with the first element direction one of the following angles $\varphi$ with a tolerance of +/- 0.1° and the channel width BK of the channel is smaller than or equal to the maximum width BKmax assigned to the angle $\varphi$:

- an angle $\varphi[°]$ from the group 11.31°, 14.04°, 18.44°, 26.57°, 45° with an assigned maximum width BKmax [μm] in accordance with

$$BK_{max,0} = AF\sin\varphi - DG\cos\varphi$$

or
- an angle $\varphi[°] = 33.69°$, with an assigned maximum width BKmax [μm] in accordance with

$$BK_{max,0} = AF\cos\varphi - (2DG + AF)\sin\varphi.$$

6. Screen-printing forme (1, 1') according to claim 5, **characterised in that** the spacing AF and diameter DG are therefore selected in such a way that

- in the case of the condition BKmax = $BK_{max1}$ and an angle $\varphi[°]$ from the group 11.31°, 14.04°, 18.44°, 26.57°, 45°, the following condition additionally applies:

$$\varphi > \tan^{-1}\left(\frac{DG}{DG+AF}\right)$$

- and in the case of angle $\varphi[°] = 33.69°$, the following condition additionally applies:

$$\varphi > \tan^{-1}\left(\frac{AF}{AF+DG}\right),$$

- in the case of the condition BKmax = $BK_{max0}$ and an angle $\varphi[°]$ from the group 11.31°, 14.04°, 18.44°, 26.57°, 45°, the following condition additionally applies:

$$\varphi > \tan^{-1}\left(\frac{DG}{AF}\right)$$

- and in the case of angle $\varphi[°] = 33.69°$, the following condition additionally applies:

$$\varphi > \tan^{-1}\left(\frac{AF}{AF+DG}\right).$$

**EP 4 014 256 B1**

7.  Screen-printing device for application of a screen-printing paste (2) to a substrate,

    having a screen-printing forme (1, 1') according to any one of the preceding claims, and at least one squeegee (3), wherein the screen-printing device is configured to apply screen-printing paste (2) to a substrate through the screen-printing forme (1, 1') by means of the squeegee.

8.  Screen-printing process for application of a screen-printing paste (2) to a substrate,

    wherein screen-printing paste (2) is applied to a substrate through a screen-printing forme (1, 1') by means of at least one squeegee (3),
    **characterised in that**
    a screen-printing forme (1, 1') according to any one of claims 1 to 5 is used.

9.  Use of a screen-printing forme (1, 1') according to any one of claims 1 to 5 in a screen-printing process.


**Revendications**

1.  Écran de sérigraphie (1, 1') à usage dans un procédé de sérigraphie, en particulier pour la fabrication d'une structure de contact métallique d'une cellule solaire photovoltaïque,

    comprenant un tissu sérigraphique (1b) comprenant une pluralité d'éléments de tissu allongés qui sont disposés selon une première direction d'éléments et une seconde direction d'élément, perpendiculaire à la première direction,
    et comprenant un pochoir (1c), disposé contre le tissu sérigraphique (1b), qui présente au moins une ouverture sous forme d'un canal rectiligne avec une largeur de canal BK,
    dans lequel les éléments de tissu présentent dans la première direction d'éléments un espacement AF et dans la seconde direction d'éléments un espacement qui s'écarte de moins de 5 % d'AF, et les éléments de tissu présentent dans la première direction d'éléments un diamètre DG et dans la seconde direction d'éléments un diamètre qui s'écarte de moins de 5 % de DG,
    **caractérisé en ce que**
    le canal (1d) forme avec la première direction d'éléments un des angles φ suivants avec une tolérance de ± 0,1° et la largeur de canal BK du canal est inférieure ou égale à la largeur maximale BKmax associée à l'angle φ :

    - un angle φ[°] dans le groupe 11,31°, 14,04°, 18,44°, 26,57°, 45° avec une largeur maximale BKmax [μm] associée selon

    $$BK_{max} = (2DG + AF)\sin\varphi + DG\,\cos\varphi$$

    ou
    - un angle φ[°] = 33,69°, avec une largeur maximale BKmax [μm] associée selon

    $$BK_{max} = (2DG + AF)\cos\varphi - AF\,\sin\varphi$$

    et la largeur de canal BK est inférieure à l'espacement entre deux éléments de tissu dans la seconde direction du fil et dans la première direction du fil.

2.  Écran de sérigraphie (1, 1') selon la revendication 1,
    **caractérisé en ce que**
    les éléments de tissu présentent dans une première direction d'éléments un espacement AF et dans une seconde direction d'éléments un espacement qui s'écarte de moins de 2 % d'AF, de préférence est égal à l'espacement AF, et/ou les éléments de tissu dans une première direction d'éléments présentent un diamètre DG et dans une seconde direction d'éléments un diamètre qui s'écarte de moins de 2 % de DG, en particulier est égal au diamètre DG.

3.  Écran de sérigraphie (1, 1') selon l'une quelconque des revendications précédentes,
    **caractérisé en ce que**

14

le pochoir (1c) présente plusieurs canaux rectilignes parallèles, en particulier au moins 0,5 canal / mm.

4. Écran de sérigraphie (1, 1') selon la revendication 3,
   **caractérisé en ce que**
   les canaux présentent un espacement qui correspond à un multiple entier de l'espacement des éléments de tissu dans une première et/ou une seconde direction du fil.

5. Écran de sérigraphie (1, 1') selon l'une quelconque des revendications précédentes,
   **caractérisé en ce que**

   le canal (1d) forme avec la première direction d'éléments un des angles φ suivants avec une tolérance de $\pm$ 0,1° et la largeur de canal BK du canal est inférieure ou égale à la largeur maximale BKmax associée à l'angle φ :

   - un angle φ[°] dans le groupe 11,31°, 14,04°, 18,44°, 26, 57°, 45° avec une largeur maximale BKmax [μm] associée selon

   $$BK_{max,21} = AF\ sin\varphi + DG\ cos\varphi$$

   ou
   - un angle φ[°] = 33,69°, avec une largeur maximale BKmax [μm] associée selon

   $$BK_{max,21} = (2DG + AF)(cos\varphi - sin\varphi)$$

   en particulier

   le canal (1d) forme avec la première direction d'éléments un des angles φ suivants avec une tolérance de $\pm$ 0,1° et la largeur de canal BK du canal est inférieure ou égale à la largeur maximale BKmax associée à l'angle φ :

   - un angle φ[°] dans le groupe 11,31°, 14,04°, 18,44°, 26,57°, 45° avec une largeur maximale BKmax [μm] associée selon

   $$BK_{max,1} = (2DG + AF)sin\varphi - DG\ cos\varphi$$

   ou
   - un angle φ[°] = 33,69°, avec une largeur maximale BKmax [μm] associée selon

   $$BK_{max,1} = AF(cos\varphi - sin\varphi),$$

   de préférence

   le canal (1d) forme avec la première direction d'éléments un des angles φ suivants avec une tolérance de $\pm$ 0,1° et la largeur de canal BK du canal est inférieure ou égale à la largeur maximale BKmax associée à l'angle φ :

   - un angle φ[°] dans le groupe 11,31°, 14,04°, 18,44°, 26,57°, 45° avec une largeur maximale BKmax [μm] associée selon

   $$BK_{max,0} = AF\ sin\varphi - DG\ cos\varphi$$

   ou
   - un angle φ[°] = 33,69°, avec une largeur maximale BKmax [μm] associée selon

   $$BK_{max,0} = AF\ cos\varphi - (2DG + AF)sin\varphi.$$

6. Écran de sérigraphie (1, 1') selon la revendication 5,
   **caractérisé en ce que**

   l'espacement AF et le diamètre DG sont choisis de manière telle que

   - avec la condition BKmax = $BK_{max1}$ et avec un angle $\varphi[°]$ dans le groupe 11,31°, 14,04°, 18,44°, 26,57°, 45° s'applique en plus la condition

   $$\varphi > tan^{-1}\left(\frac{DG}{DG + AF}\right)$$

   et avec un angle $\varphi[°]$ = 33,69° s'applique en plus la condition

   $$\varphi > tan^{-1}\left(\frac{AF}{AF + DG}\right)$$

   - avec la condition BKmax = $BK_{max0}$ et avec un angle $\varphi[°]$ dans le groupe 11,31°, 14,04°, 18,44°, 26,57°, 45° s'applique en plus la condition

   $$\varphi > tan^{-1}\left(\frac{DG}{AF}\right)$$

   et avec un angle $\varphi[°]$ = 33,69° s'applique de plus la condition

   $$\varphi > tan^{-1}\left(\frac{AF}{AF + DG}\right)$$

7. Dispositif de sérigraphie pour étaler une pâte sérigraphique (2) sur un substrat, comprenant un écran de sérigraphie (1, 1') selon l'une quelconque des revendications précédentes, et au moins une raclette (3), dans lequel le dispositif de sérigraphie est conçu pour, au moyen de la raclette, appliquer la pâte sérigraphique (2) par l'intermédiaire de l'écran de sérigraphie (1, 1') sur un substrat.

8. Procédé de sérigraphie pour appliquer une pâte sérigraphique (2) sur un substrat,

   dans lequel au moyen d'une raclette (3) de la pâte sérigraphique (2) est appliquée par l'intermédiaire de l'écran de sérigraphie (1, 1') sur un substrat,
   **caractérisé en ce que**
   un écran de sérigraphie (1, 1') selon un des revendications 1 à 5 est utilisé.

9. Usage d'un écran de sérigraphie (1, 1') selon l'une quelconque des revendications 1 à 5 dans un procédé de sérigraphie.

Figur 1

Figur 2

Figur 3

1

1a

1b

1c

1d

Figur 4

1

1a

1d

1b

1c

A

Figur 5

A

1b     1c

1d     BK     φ

DG

AF

Figur 6

1c     1b
a)
1d     K

1c     1b
b)
1d     K

1c     1b
c)
1d     K

1c     1b
d)
1d     K

Figur 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007059794 A1

- US 2009025581 A1